# EUROPÄISCHE PATENTSCHRIFT

(11) **EP 1 986 935 B1**
(45) Veröffentlichungstag und Bekanntmachung des Hinweises auf die Patenterteilung: **04.11.2009**
(21) Anmeldenummer: 07721885.7
(22) Anmeldetag: 06.02.2007
(51) Int. Cl.: G01R 31/02, G01R 31/28

(54) **VORRICHTUNG ZUR ÜBERPRÜFUNG EINER ELEKTROTECHNISCHEN PLATINE MIT EINER LEITERBAHN**
APPARATUS FOR CHECKING AN ELECTRICAL PRINTED CIRCUIT BOARD HAVING A CONDUCTOR TRACK
DISPOSITIF DE CONTRÔLE D'UNE PLATINE ÉLECTROTECHNIQUE AVEC UNE PISTE CONDUCTRICE

(30) Priorität: 23.02.2006 DE 102006008443
(43) Veröffentlichungstag der Anmeldung: 05.11.2008
(73) Patentinhaber: OBO Bettermann GmbH & Co. KG, 58710 Menden (DE)
(72) Erfinder: OGOREK, Udo, 59077 Hamm (DE); SCHURWANZ, Jürgen, 58708 Menden (DE); TRINKWALD, Jürgen, 58708 Menden (DE)
(74) Vertreter: Köchling, Conrad-Joachim
(86) Internationale Anmeldenummer: PCT/DE2007/000215
(87) Internationale Veröffentlichungsnummer: WO 2007/095887

(56) Entgegenhaltungen:
- WO-A2-99/28755
- DE-U1- 29 724 817
- GB-A- 2 170 068
- JP-A- 58 011 877
- US-A- 4 056 773

## Beschreibung

Die Erfindung betrifft eine Vorrichtung zur Überprüfung einer elektrotechnischen Platine mit einer Leiterbahn, wobei die Leiterbahn einen durchgehenden, an eine Stromquelle angeschlossenen Strompfad bildet, indem zum Beispiel Leiterbahnabschnitte überbrückt und somit verbunden sind oder mit seriellen elektrotechnischen Bauteilen bestückt und somit verbunden sind.

Im Stand der Technik ist es bekannt, elektrotechnische Platinen, die Leiterbahnen aufweisen, mit anderen Elementen zu kombinieren, beispielsweise mit Blitzstromableitern und Steuerkondensatoren. Eine derartige Ausbildung ist beispielsweise aus der DE 297 24 817 U1 bekannt. Hierbei ist die aus seriell geschalteten Teilfunkenstrecken bestehende Funkenstrecke einerseits an einem Phase führenden Leiter eines Stromversorgungsnetzes und andererseits an Bezugserde angeschlossen.

Bei solchen Blitzstromableitern mit mehrfach Funkenstreckentechnik werden zur Ansteuerung der einzelnen Funkenstrecken Hochvoltkondensatoren verwendet. Diese Hochvoltkondensatoren befinden sich zusammen mit Federkontakten, die den Kontakt zu den Graphitscheiben der Teilfunkenstrecke herstellen, auf einer Platine. Alle Hochvoltkondensatoren sind auf der.einen Seite durch die Leiterbahn der Platine miteinander verbunden, so dass sie am gleichen Bezugspotential, insbesondere Erdpotential liegen. Bei solchen Einrichtungen, aber auch bei andern elektrotechnischen Einrichtungen, bei denen eine Platine mit Leiterbahn vorgesehen ist, ist eine Überprüfung und Überwachung der Leiterbahn der Platine notwendig. Beispielsweise kann bei dem beschriebenen Ausführungsbeispiel durch den Blitzstromableitvorgang und den automatisch einsetzenden Folgestromlöschvorgang in der Funkenstrecke Wärme entstehen. Durch die danach folgende Abkühlung wird die Platine mechanisch belastet. Wird der Ableiter häufig sehr hoch belastet, ist es zumindest theoretisch denkbar, dass durch die unterschiedlichen Temperaturausdehnungskoeffizienten der verwendeten Werkstoffe Unterbrechungen durch Risse in der Leiterbahn der Platine entstehen. Eine solche Unterbrechung der Leiterbahn ist auch durch andere Effekte möglich.

Aus der GB 2170068 A ist ein Detektor zur Erfassung von Leitungsunterbrechungen bekannt.

Auch in der WO99/28755A ist ein Schaltkreis zur Erfassung von Stromkreisunterbrechungen beschrieben.

Ähnliche Prüfschaltkreise sind in der JP 58011877 A und der US 4,056,773A angegeben.

Aufgabe der Erfindung ist es daher, eine Vorrichtung gattungsgemäßer Art zu schaffen, die eine mögliche Unterbrechung der Leiterbahn der platine überprüfbar macht, und zwar mit geringem Aufwand sowie mit äußerst geringem Stromverbrauch.

Es wäre eine Lösung denkbar, bei der durch die entsprechende Anschaltung einer Leuchtdiode parallel zur Leiterbahn der Platine durch Dauerlicht die Funktionsfähigkeit der Leiterbahn angezeigt wird, wobei dann aber der Betriebsstrom auf Dauer gesehen relativ hoch ist. Mit solch einer Einrichtung würde der für die einschlägigen Institutionen wichtige Leckstrom von maximal 1mA (gemessen im Scheitelwert der Sinuswelle) überschritten, weswegen eine solche Lösung von den entsprechenden Institutionen nicht akzeptiert wird.

Die Lösung dieser Aufgabe ist in Anspruch 1 angegeben.

Hierdurch wird eine Überprüfungsschaltung zur Verfügung gestellt, die gegebenenfalls auf der bestehenden Platine integriert werden kann. Mit der entsprechenden Prüfschaltung ist eine ständige intermittierende Überprüfung der Leitfähigkeit der Leiterbahn ermöglicht. Die Funktionsfähigkeit ist dabei durch eine entsprechend blinkende erste Leuchtdiode signalisiert. Ein Defekt wird durch ein entsprechendes Blinksignal der zweiten Leuchtdiode signalisiert. Durch die erfindungsgemäße Gestaltung kann im Vergleich zu einem Dauerlicht der Betriebsstrom ungefähr um den Faktor 80 reduziert werden. Die Kapazität des Kondensators ist beispielsweise auf 10 Mikrofarad festzulegen. Da die Prüfschaltung mit Wechselspannung beaufschlagt ist, ist dem Kondensator ein Gleichrichter vorgeschaltet. Es wird durch die erfindungsgemäße Anordnung eine getaktete kurze Lichterscheinung sehr Strom sparend zur Verfügung gestellt. Im Übrigen ist durch die Schaltungsanordnung sichergestellt, dass ein Strom, der über die Leiterbahn bestimmungsgemäß fließt, die Prüfschaltung nicht belastet.

Vorteilhafte Weiterbildungen sind in den Ansprüche 2 bis 10 angegeben. Der Vorwiderstand mit vorzugsweise 1 MΩ dient der Strombegrenzung. Als Gleichrichter ist eine entsprechende Gleichrichterdiode in die Schaltung integriert.

Der DIAC ist ein elektronischer Schalter, der dann, wenn der Kondensator aufgeladen wird sperrt und in dem Fall, dass der Kondensator aufgeladen ist, öffnet und die Entladung des Kondensators über die Prüfschaltung ermöglicht. Der dem DIAC nachgeschaltete Widerstand dient dazu, die Entladung des Kondensators zu verlangsamen, so dass die erste Diode nicht nur sehr kurz aufblinkt, sondern längere Zeit leuchtet. Die Sperrdioden, die bis zu 1000 Volt sperren, dienen als Schutz für den Transistor.

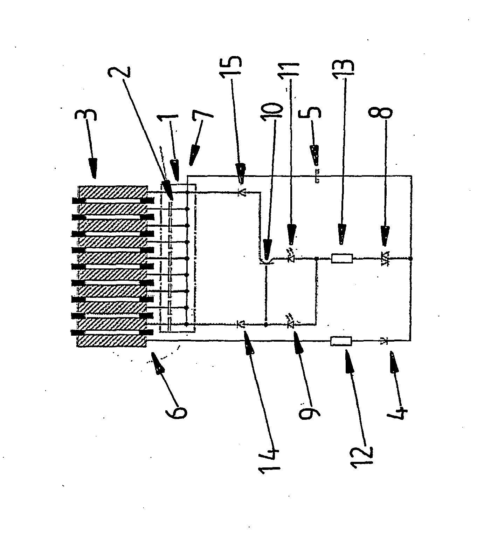

Eine konkrete Verwirklichung der erfindungsgemäßen Vorrichtung ist in der Zeichnung dargestellt und im Folgenden näher beschrieben.

Die einzige Zeichnung zeigt eine Platine mit Prüfschaltung.

Bei 1 ist eine Platine mit einer Leiterbahn und einer Anzahl von an die Leiterbahn angeschlossenen Kondensatoren 2 gezeigt. Dabei können die Kondensatoren 2 Bestandteil einer blitzstromtragfähigen Funkenstrecke sein, wie dies in der DE 297 24 817 U1 gezeigt ist. Im Ausführungsbeispiel ist eine blitzstromtragfähige Funkenstrecke gezeigt, die aus einer Vielzahl von seriell geschalteten Teilfunkenstrecken 3 besteht. Dabei sind die Teilfunkenstrecken 3 mit Ausnahme der im Blitzstromereignisfall ersten ansprechenden Teilfunkenstrecke durch Impedanzen in Form von Kondensatoren beschaltet, so dass sie sukzessive durchschalten. Die zweite und jede weitere Teilfunkenstrecke ist über die Impedanzen (Kondensatoren 2) direkt an ein gemeinsames Bezugspotential, beispielsweise an Erde, angeschaltet. Die einzelnen Leiterbahnabschnitte der Platine 1 sind durch die angeschlossenen Teilfunkenstrecken und Impedanzen, die seriell zueinander geschaltet sind, überbrückt.

Die Prüfschaltung selbst besteht aus einem parallel zur Leiterbahn der Platine 1 geschalteten Schaltkreis mit einem Gleichrichter 4 und einem Kondensator 5, die bei 6 an einen phase- Leiter eines Stromversorgungsnetzes sowie bei 7 an das eine Ende der Leiterbahn der Platine 1 angeschlossen ist, wobei dieser Anschluss Bezugspotential führt, beispielsweise Erdpotential oder Neutralpotential.

Weiterhin besteht die Prüfschaltung aus einer Prüfstrecke mit einem DIAC 8 und einer ersten Leuchtdiode 9, wobei der DIAC an die Leitung zwischen der Phase führenden Stromversorgung (bei 6) und Kondensator (bei 5) angeschlossen ist und über die erste Leuchtdiode 9 an das andere Phasenpotential führende Ende der Leiterbahn der Platine 1 angeschlossen ist. Weiterhin besteht die Prüfschaltung aus einem an den Ausgang der ersten Leuchtdiode 9 mit seiner Basis angeschalteten Schalttransistor 10, vor dessen Kollektor- Emitter- Strecke eine zweite Leuchtdiode 11, die zwischen DIAC 8 und Transistor 10 geschaltet ist, eingeschaltet ist, wobei der Emitter des Transistors 10 an das Bezugspotential am Ende der Leiterbahn der Platine 1 angeschlossen ist.

Der Gleichrichter 4 ist durch eine Gleichrichterdiode gebildet, wobei vor den Gleichrichter 4 als Strombegrenzer ein Vorwiderstand 12 geschaltet ist. Dem DIAC 8 ist ein Widerstand 13 nachgeschaltet, mittels dessen die Entladung des Kondensators 5 verlangsamt wird, so dass die entsprechende Diode länger'leuchtet.

Die erste Leuchtdiode 9 emittiert grünes Licht, während die zweite Leuchtdiode 11 rotes Licht emittiert. Zwischen dem Ausgang der ersten Leuchtdiode 9 und die Leiterbahn der Platine 1 ist eine Sperrdiode 14 geschaltet. Ebenso ist zwischen Emitter des Transistors 10 und das Bezugspotential führende Ende der Leiterbahn der Platine 1 eine Sperrdiode 15 geschaltet.

Im Ausführungsbeispiel wird beispielsweise der Betriebswechselstrom von 255 Volt durch den Vorwiderstand von 1MΩ auf 361µA im Scheitelwert der Sinuswelle begrenzt. Durch die Einweggleichrichtung mittels des Gleichrichters 4 wird dann ein Effektivwert von 127,5µA erreicht. Bei einer Wechselnetzspannung von 230 Volt beträgt der effektive Betriebsstrom etwa 115µA.

Der für einschlägige Institutionen wichtige Leckstrom von maximal 1mA (gemessen im Scheitel der Sinuswelle) wird damit deutlich unterschritten. Bei einer Spannung von 255 Volt beträgt die Leistungsaufnahme dann etwa 0,026 W.

Sofern die Leiterbahn der Platine 1 keine Störung aufweist, erfolgt zunächst die Aufladung des Kondensators 5 und anschließend die Entladung des Kondensators unter Aufleuchten der ersten Leuchtdiode 9.

Falls die Leiterbahn der Platine 1 Unterbrechungen aufweist oder Defekte, so ist der Stromfluss über die Prüfschaltung, insbesondere über die erste Leuchtdiode 9 unterbrochen. In diesem Falle liegt aber bei geladenem Kondensator 5, wenn dieser sich entlädt, eine Steuerspannung an der Basis des Transistors 10 an, so dass dieser durchschaltet. Infolgedessen leuchtet die zweite Leuchtdiode 11 auf, bis der Kondensator 5 entladen ist. Der Vorgang wiederholt sich, gesteuert durch den DIAC 8.

Die Erfindung ist nicht auf das Ausführungsbeispiel beschränkt, sondern im Rahmen der Ansprüche vielfach variabel.

## Patentansprüche

1. Vorrichtung zur Überprüfung einer elektrotechnischen Platine (1) mit einer Leiterbahn, wobei die Leiterbahn einen durchgehenden, an eine Stromquelle angeschlossenen Strompfad bildet, indem. Leiterbahnabschnitte überbrückt und somit verbunden sind oder mit seriellen elektrotechnischen Bauteilen (2,3) bestückt und somit verbunden sind, die einerseits an einen Phase führenden Leiter der Stromquelle und andererseits an Bezugserde oder einen Neutralleiter angeschlossen sind, wobei eine Prüfschaltung vorgesehen ist, bestehend aus
- einem parallel zur Leiterbahn der Platine geschalteten Schaltkreis mit einem Gleichrichter (4) und einem Kondensator (5), der an den Phasenleiter und den Erdleiter bzw. Neutralleiter angeschlossen ist,
- einer Prüfstrecke mit einem DIAC (8) und einer ersten Leuchtdiode (9), wobei der DIAC (8) zwischen dem Gleichrichter (4) und dem Kondensator (5) angeschlossen ist und über den Eingang und Ausgang der ersten Leuchtdiode (9) an das Phasenpotential führende Ende der Leiterbahn angeschlossen ist,
- einem an den Ausgang der ersten Leuchtdiode (9) mit seiner Basis angeschalteten Schalttransistor (10), vor dessen Kollektor-Emitter Strecke eine zweite Leuchtdiode (11), die zwischen DIAC (8) und Transistor (10) geschaltet ist, geschaltet ist, wobei der Emitter an das an den Erdleiter bzw. Neutralleiter angeschlossene Ende der Leiterbahn der Platine angeschaltet ist.

2. Vorrichtung nach Anspruch 1, **dadurch gekennzeichnet, dass** der Gleichrichter (4) durch eine Gleichrichterdiode gebildet ist.

3. Vorrichtung nach einem der Ansprüche 1 oder 2, **dadurch gekennzeichnet, dass** vor den Gleichrichter (4) als Strombegrenzer ein Vorwiderstand (12) geschaltet ist.

4. Vorrichtung nach Anspruch 3, **dadurch gekennzeichnet, dass** der Vorwiderstand (12) mindestens 1 MΩ beträgt.

5. Vorrichtung nach einem der Ansprüche 1 bis 4, **dadurch gekennzeichnet, dass** dem DIAC (8) ein Widerstand (13) vorgeschaltet ist.

6. Vorrichtung nach Anspruch 5, **dadurch gekennzeichnet, dass** der Widerstand (13) etwa 120 Ω beträgt.

7. Vorrichtung nach einem der Ansprüche 1 bis 6, **dadurch gekennzeichnet, dass** die erste Leuchtdiode (9) grünes Licht emittiert.

8. Vorrichtung nach einem der Ansprüche 1 bis 7, **dadurch gekennzeichnet, dass** die zweite Leuchtdiode (11) rotes Licht emittiert.

9. Vorrichtung nach einem der Ansprüche 1 bis 8, **dadurch gekennzeichnet, dass** zwischen den Ausgang der ersten Leuchtdiode (9) und Leiterbahn eine Sperrdiode (14) geschaltet ist, die vorzugsweise bis 1000 Volt sperrt.

10. Vorrichtung nach einem der Ansprüche 1 bis 9, **dadurch gekennzeichnet, dass** zwischen den Emitter des Transistors (10) und das an den Erdleiter bzw. Neutralleiter angeschlossene Ende der Leiterbahn eine Sperrdiode (15) geschaltet ist, die vorzugsweise bis 1000 Volt sperrt.

## Claims

1. Apparatus for checking an electrical printed circuit board (1) having a conductor track, wherein the conductor track forms a continuous current path connected to a current source by conductor track portions being bridged and thus connected or being equipped with serial electrical components (2, 3) and thus connected, these being connected on the one hand to a phase-carrying conductor of the current source and on the other hand to reference ground or to a neutral conductor, wherein a test circuit is provided, consisting of
- a circuit connected in parallel with the conductor track of the printed circuit board, said circuit comprising a rectifier (4) and a capacitor (5) which is connected to the phase conductor and to the ground conductor or neutral conductor,
- a test section comprising a DIAC (8) and a first light-emitting diode (9), wherein the DIAC (8) is connected between the rectifier (4) and the capacitor (5) and is connected to the phase potential-carrying end of the conductor track via the input and output of the first light-emitting diode (9),
- a switching transistor (10) connected by its base to the output of the first light-emitting diode (9), upstream of the collector/emitter section of which switching transistor there is connected a second light-emitting diode (11) which is connected between the DIAC (8) and the transistor (10), wherein the emitter is connected to the end of the conductor track of the printed circuit board which is connected to the ground conductor or neutral conductor.

2. Apparatus according to claim 1, **characterised in that** the rectifier (4) is formed by a rectifier diode.

3. Apparatus according to one of claims 1 or 2, **characterised in that** a series resistor (12) is connected upstream of the rectifier (4) as a current limiter.

4. Apparatus according to claim 3, **characterised in that** the series resistor (12) is at least 1 MΩ.

5. Apparatus according to one of claims 1 to 4, **characterised in that** a resistor (13) is connected upstream of the DIAC (8).

6. Apparatus according to claim 5, **characterised in that** the resistor (13) is approximately 120 Ω.

7. Apparatus according to one of claims 1 to 6, **characterised in that** the first light-emitting diode (9) emits green light.

8. Apparatus according to one of claims 1 to 7, **characterised in that** the second light-emitting diode (11) emits red light.

9. Apparatus according to one of claims 1 to 8, **characterised in that** a blocking diode (14), which preferably blocks up to 1000 Volt, is connected between the output of the first light-emitting diode (9) and the conductor track.

10. Apparatus according to one of claims 1 to 9, **characterised in that** a blocking diode (15), which preferably blocks up to 1000 Volt, is connected between the emitter of the transistor (10) and the end of the conductor track which is connected to the ground conductor or neutral conductor.

## Revendications

1. Dispositif de contrôle d'une platine électrotechnique (1) avec une piste conductrice, la piste conductrice formant un chemin de courant ininterrompu connecté à une source de courant, des sections de piste conductrice étant court-circuitées et donc reliées ou équipées de composants électrotechniques (2, 3) série et donc reliées, qui sont connectées d'un côté à un conducteur de la source de courant conduisant une phase et de l'autre côté à la terre de référence ou à un conducteur neutre, dans lequel dispositif de contrôle est prévu un circuit de contrôle composé
- d'un circuit monté en parallèle sur la piste conductrice de la platine, comportant un redresseur (4) et un condensateur (5), qui est connecté au conducteur de phase et au conducteur de terre, respectivement au conducteur neutre,
- d'un trajet de contrôle comportant un DIAC (8) et une première diode luminescente (9), le DIAC (8) étant connecté entre le redresseur (4) et le condensateur (5) et, par l'intermédiaire de l'entrée et de la sortie de la première diode luminescente (9), connecté à l'extrémité conduisant le potentiel de phase de la piste conductrice,
- d'un transistor de commutation (10) connecté par sa base à la sortie de la première diode luminescente (9), avant le trajet collecteur-émetteur duquel est montée une deuxième diode luminescente (11) qui est montée entre le DIAC (8) et le transistor (10), l'émetteur étant connecté à l'extrémité de la piste conductrice de la platine connectée au conducteur de terre, respectivement au conducteur neutre.

2. Dispositif selon la revendication 1, **caractérisé en ce que** le redresseur (4) est formé par une diode redresseuse.

3. Dispositif selon l'une des revendications 1 ou 2, **caractérisé en ce qu'**une résistance série (12) est montée avant le redresseur (4) en guise de limiteur de courant.

4. Dispositif selon la revendication 3, **caractérisé en ce que** la résistance série (12) a une valeur d'au moins 1 MΩ.

5. Dispositif selon l'une des revendications 1 à 4, **caractérisé en ce qu'**une résistance (13) est montée en amont du DIAC (8).

6. Dispositif selon la revendication 5, **caractérisé en ce que** la résistance (13) a une valeur d'environ 120 Ω.

7. Dispositif selon l'une des revendications 1 à 6, **caractérisé en ce que** la première diode luminescente (9) émet une lumière verte.

8. Dispositif selon l'une des revendications 1 à 7, **caractérisé en ce que** la deuxième diode luminescente (11) émet une lumière rouge.

9. Dispositif selon l'une des revendications 1 à 8, **caractérisé en ce qu'**entre la sortie de la première diode luminescente (9) et la piste conductrice est montée une diode de blocage (14) qui bloque de préférence jusqu'à 1000 volts.

10. Dispositif selon l'une des revendications 1 à 9, **caractérisé en ce qu'**entre l'émetteur du transistor (10) et l'extrémité de la piste conductrice connectée au conducteur de terre, respectivement au conducteur neutre, est montée une diode de blocage (15) qui bloque de préférence jusqu'à 1000 volts.
